# EUROPEAN PATENT APPLICATION

(11) **EP 4 700 771 A1**
(43) Date of publication of application: **25.02.2026**
(21) Application number: 24196221.6
(22) Date of filing: 23.08.2024
(51) Int. Cl.: G10L 21/034, G10L 25/78, H03G 3/30, H03G 3/32, G10L 25/30

(54) **DYNAMICAL ADJUSTMENT OF SOUND VOLUME INSIDE A VEHICLE**

(71) Applicant: Valeo Telematik Und Akustik GmbH, 61381 Friedrichsdorf (DE)
(72) Inventor: SAMER, Sara, 94000 Créteil (FR); ELFAKHARANY, Ahmed, 94000 Créteil (FR); ELKADY, Aya, 94000 Créteil (FR); EWEDA, Omar, 94000 Créteil (FR); ELKARASHILY, Ahmed, 94000 Créteil (FR)
(74) Representative: Delaval, Guillaume Laurent

(57) **Abstract**

The disclosure notably relates to a computer-implemented method of machine-learning for use in a dynamical adjustment of a sound volume of one or more loudspeakers inside a vehicle. The method comprises obtaining a dataset of audio samples. Each audio sample having a label representing a presence or absence of passenger voice. The method also comprises training a machine-learning model based on the dataset. The machine-learning is configured to receive an input audio sample. The machine-learning is configured to output information relative to presence or absence of passenger voice in the input audio sample.

## Description

### TECHNICAL FIELD

The disclosure relates to the field of computer programs and systems, and more specifically to methods, systems and programs related to machine-learning and dynamical adjustment of a sound volume of one or more loudspeakers inside a vehicle.

### BACKGROUND

In the context of vehicles, passengers often ride their vehicle with an audio source playing on loudspeakers mounted in the vehicle, for example music playing in the vehicle. A passenger needs to adjust repeatedly the audio volume to hold a conversation with another passenger or with individuals outside of the vehicle. Such a repeated need for adjusting volume disrupts communication between the passengers, resulting in delayed responses and even causing urgent messages to go unheard. This not only leads to frustration from the passengers, but also poses potential safety risks, as the driver might get distracted while adjusting the audio volume or other settings in order to hear the conversation better.

Within this context, there is still a need for an improved solution for dynamical adjustment of a sound volume of one or more loudspeakers inside a vehicle.

### SUMMARY

It is therefore provided a computer-implemented method of machine-learning for use in a dynamical adjustment of a sound volume of one or more loudspeakers inside a vehicle. The method comprises obtaining a dataset of audio samples. Each audio sample has a label representing a presence or absence of passenger voice. The method also comprises training a machine-learning model based on the dataset. The machine-learning is configured to receive an input audio sample. The machine-learning is configured to output information relative to presence or absence of passenger voice in the input audio sample.

The method of machine-learning may comprise one or more of the following:
- the information relative to presence or absence of passenger voice in the input audio sample comprises a confidence score;
- the machine-learning model is a convolutional neural network comprising convolutional layers and/or recurrent layers; and/or
- the machine-learning model is a binary classifier.

It is further provided a method for dynamical adjustment of a sound volume of one or more loudspeakers inside a vehicle using a machine-learning model trained according to the method. The method comprises receiving a sequence of consecutive input audio samples from inside a vehicle. The method also comprises applying the machine-learning model to each input audio sample, thereby outputting, for each input audio sample, information relative to presence or absence of passenger voice in the input audio sample. The method also comprises reducing the sound volume of one or more loudspeakers of the vehicle based on the output information.

The method for dynamical adjustment may comprise one or more of the following:
- the method comprises:
   -- computing a confidence score relative to a presence of passenger voice in the sequence of consecutive input audio samples; and
   -- reducing the sound volume of loudspeakers of the vehicle if the confidence score is above a predetermined threshold;
- the predetermined threshold is between 0.6 and 1, preferably equal to 0.8;
- the method comprises capturing the input audio samples with microphones installed inside the vehicle.

It is further provided a computer program comprising instructions for performing the method of machine-learning and/or the method for dynamical adjustment.

It is further provided a computer readable storage medium having recorded thereon the computer program.

It is further provided a system comprising a processor coupled to a memory, the memory having recorded thereon the computer program.

It is further provided a vehicle equipped with the system.

### BRIEF DESCRIPTION OF THE DRAWINGS

Non-limiting examples will now be described in reference to the accompanying drawings, where:
- FIG.s 1 and 2 shows examples of systems for performing the methods of the present disclosure; and
- FIG.s 3 to 9 illustrate the methods.

### DETAILED DESCRIPTION

It is proposed a computer-implemented method of machine-learning. The machine-learning method may be for use in a dynamical adjustment of a sound volume of one or more loudspeakers inside a vehicle. In particular, the trained machine-learning model may be used for such dynamical adjustment.

The machine-learning method comprises obtaining a dataset of audio samples. Each audio sample has a label (i.e., piece of data) representing a presence or absence of passenger voice (inside the audio signal-i.e., the sound - represented by the audio sample). The machine-learning method also comprises training a machine-learning model (e.g., neural network) based on the dataset. The machine-learning model is (after the training) configured to receive an (e.g., any) input audio sample, and to output information relative to presence or absence of passenger voice in the input audio sample (i.e., inside the audio signal - i.e., the sound - represented by the input audio sample).

Such a machine-learning method forms an improved solution for dynamical adjustment of a sound volume of one or more loudspeakers inside a vehicle.

Indeed, the machine-learning method configures (i.e., trains) the machine-learning model to output (accurate) information relative to the presence or absence of passenger voice in the input audio sample accurately. This is all thanks to the machine-learning method leveraging from the dataset of audio samples which provides a high variability of examples of the presence or absence of passenger voice under a variety of scenarios, e.g., while background voice or music is present on the actual captured audio by a microphone in the vehicle. In examples, the dataset may comprise audio samples (i.e., training examples) containing music, e.g., including audio samples containing both music and passenger voice and/or audio samples containing music and no passenger voice. Thus, the machine-learning model allows the inference of passenger voice even under a noisy environment.

It is also provided a method for dynamical adjustment of a sound volume of one or more loudspeakers inside a vehicle (also called "dynamical adjustment method") using a machine-learning model trained according to the machine-learning method. The dynamical adjustment method comprises receiving a sequence of consecutive input audio samples from inside a vehicle. The dynamical adjustment method comprises applying the machine-learning model to each input audio sample. The dynamical adjustment method thereby comprises outputting, for each input audio sample, information relative to presence or absence of passenger voice in the input audio sample. The dynamical adjustment method further comprises reducing the sound volume of one or more loudspeakers of the vehicle based on the output information, for example if the output information is indicative of presence of passenger voice or a high probability of presence of passenger voice. Alternatively or additionally, the dynamical adjustment method may further return to the previous volume (i.e., go back to the volume previous to when the passenger voice is detected), for example if the output information is indicative of absence of passenger voice or a high probability of absence of passenger voice. The dynamical adjustment method may comprise automatically alternating such reduction or increase of the sound volume of the one or more loudspeakers of the vehicle based on the output information, as the output information evolves while the method comprises continuously receiving the sequence of consecutive input audio samples from inside the vehicle and repeatedly applying the machine-learning model to each received input audio sample.

The dynamical adjustment method may be performed after performing the machine-learning method, or be performed separately from the machine-learning method (in which case the trained machine-learning model may be obtained in any manner, for example retrieved from memory).

The dynamical adjustment method thus leverages from the machine-learning method to adjust the sound volume of the one or more loudspeakers. Indeed, the dynamical adjustment method uses the output information relative to the presence or absence of passenger voice to the sound volume of or more loudspeakers inside the vehicle based thereon. For example, the method may reduce automatically and dynamically the sound volume when there is a presence of passenger voice, while the sound volume may be maintained when there is an absence of passenger voice. Thus, the machine-learning model enables the dynamical adjustment method to efficiently and fully automatically control of sound volume while allowing the passenger to have a seamless experience while inside the moving vehicle, e.g., while having a conversation with another passenger or while on the phone. The dynamical adjustment method thus allows for the passenger to maintain concentration while driving, thanks to the automatic reduction of the sound volume of one or more loudspeakers.

The methods of the present disclosure are computer-implemented. This means that steps (or substantially all the steps) of the methods are executed by at least one computer, or any system alike. Thus, steps of the methods are performed by the computer, possibly fully automatically, or, semi-automatically. In examples, the triggering of at least some of the steps of the methods may be performed through user-computer interaction. The level of user-computer interaction required may depend on the level of automatism foreseen and put in balance with the need to implement user's wishes. In examples, this level may be user-defined and/or predefined.

A typical example of computer-implementation of a method of the present disclosure is to perform the method with a system adapted for this purpose.

The dynamical adjustment method may be performed on a system, e.g., configured to be mounted on a vehicle. The system may comprise a processor coupled to a memory, the memory having recorded thereon a computer program comprising instructions for performing the dynamical adjustment method. The memory is any hardware adapted for such storage, possibly comprising several physical distinct parts (e.g. one for the program). The system may also comprise a communication interface configured for obtaining captured audio samples from the microphones and/or to adjust the volume of the one or more loudspeakers. The system may be configured to be mounted inside the moving vehicle, for example being affixed to the vehicle or alternatively being configured to be removed from the vehicle.

The machine-learning method may be performed on a system (called "training system herein") comprising a processor coupled to a memory, the memory having recorded thereon a computer program comprising instructions for performing the machine-learning method. The memory may also store the dataset. The memory is any hardware adapted for such storage, possibly comprising several physical distinct parts (e.g. one for the program, and possibly one for the dataset). The system may be a standalone computer or a server, e.g., part of a cloud computing environment.

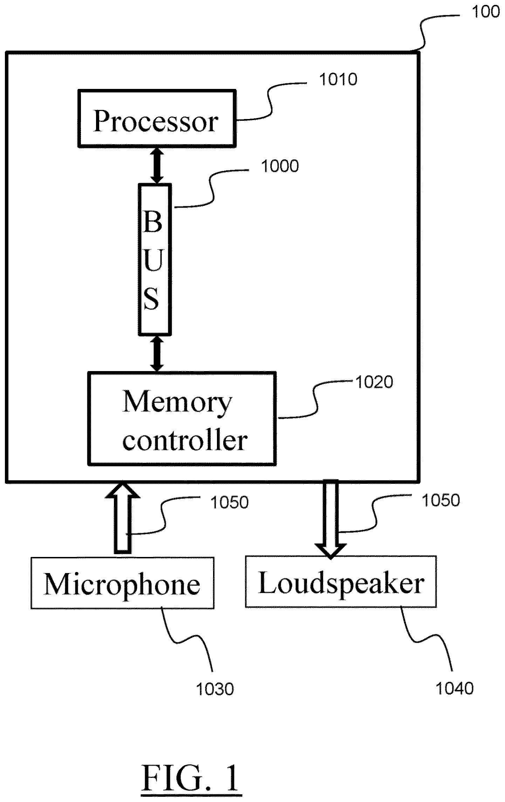

FIG. 1 shows an example of the system configured to be mounted on the vehicle.

The computer 100 of the example comprises a processor or processing unit such as a central processing unit (CPU) 1010 connected to an internal communication BUS 1000. A random access memory (RAM) may be optionally connected to the BUS (not shown). A memory controller 1020 manages accesses to a mass memory device, such as hard drive or other form of non-volatile memory such as EPROM, EEPROM, and flash memory devices. Any of the foregoing may be supplemented by, or incorporated in, specially designed ASICs (application-specific integrated circuits). The computer may optionally also include a display, e.g., a touch screen (not shown). The computer 100 may be coupled with a microphone 1030 and with loudspeakers 1040 through ports or interfaces 1050.

It is further provided a vehicle equipped with the system. The vehicle may be a four-wheeled motorized vehicle. The vehicle may have one or more microphones and one or more loudspeakers. The loudspeakers may be installed at different places, for example installed at each respective door and/or installed at the back of the vehicle.

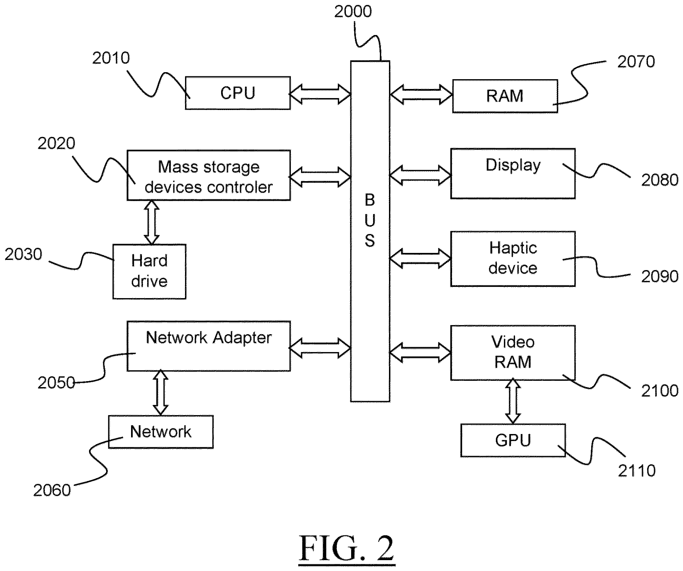

FIG. 2 shows an example of the training system, e.g. a workstation.

The workstation of the example comprises a central processing unit (CPU) 2010 connected to an internal communication BUS 2000, a random access memory (RAM) 2070 also connected to the BUS. The workstation is further provided with a graphical processing unit (GPU) 2110 which is associated with a video random access memory 2100 connected to the BUS. Video RAM 2100 is also known in the art as frame buffer. A mass storage device controller 2020 manages accesses to a mass memory device, such as hard drive 2030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 2050 manages accesses to a network 2060. The workstation may also include a haptic device 2090 such as cursor control device, a keyboard or the like. A cursor control device is used in the workstation to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the workstation may comprise a sensitive pad, and/or a sensitive screen.

The computer program may comprise instructions executable by a computer, the instructions comprising means for causing a system as above (e.g., the training system or a system configured to be mounted on the vehicle) to perform the methods of the present disclosure. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method.

The machine-learning method is further discussed.

The machine-learning method is for use in a dynamical adjustment of a sound volume of one or more loudspeakers inside a vehicle. By "dynamical adjustment" it is meant that the machine-learning model trained by the machine-learning method to participate in (and thus enable) adjusting the sound volume (e.g., increasing or reducing the sound volume) of the one or more loudspeakers automatically and substantially real-time (e.g., in less than a predetermined duration, such as 10 seconds or 1 second) after an event detected based on the information outputted by machine-learning model. The event may comprise detection of any kind of presence or absence of human speech inside the vehicle. The event may comprise, for example, detection of a conversation between passengers inside the vehicle or a conversation of a passenger on the phone.

Adjusting the sound volume may be triggered upon detecting the presence of the passenger voice, for example in the event that the input audio samples record a discussion between passengers or in the event that the input audio samples record a passenger speaking on the phone. The machine-learning model trained according to the machine-learning method may for example enable the dynamical adjustment method to reduce the sound volume of the one or more loudspeakers according to the detected presence of passenger voice, as it will be explained below. The dynamical adjustment method may further comprise increasing back the sound volume (e.g., to a predetermined set point) when detecting that the event that triggered the reduction of sound volume is over (for example, when the passengers are no longer speaking or while the passenger finishes the call).

As known per se from the field of machine-learning, the processing of an input by a neural network includes applying operations to the input, the operations being defined by data including weight values. Training a neural network thus includes determining values of the weights based on a dataset (configured for such training), such a dataset being possibly referred to as a learning dataset or a training dataset. The values may be optimal values with respect to an optimization program, for example a minimization of a loss function.

For that, the dataset includes data pieces each forming a respective training sample. The training samples represent the diversity of the situations where the neural network is to be used after being trained. The dataset may comprise a number of training samples higher than 100, 1000, 10000, or more (e.g., 25000), or 100000 or more.

The machine-learning method comprises obtaining a dataset of audio samples. The machine-learning method may comprise obtaining the dataset from a non-volatile storage medium or download it from a remote location.

Each audio sample has a label representing a presence or absence of passenger voice. In other words, the dataset stores includes training samples of audio samples associated with (in the dataset) a respective label. The label may comprise any kind of information indicative of the presence or absence of the passenger voice. For example, the label may comprise the number "0" to indicate the absence of passenger voice or "1" to indicate the presence of passenger voice. Each audio sample may be of a predetermined duration, for example 20 milliseconds or more, e.g., 60 milliseconds or more, for example 96 milliseconds. The audio samples of the dataset may all have the same duration, or alternatively different durations (for at least two audio samples).

The machine-learning model may be a convolutional neural network. The convolutional neural network function is a computer-implemented/computerized data structure that is a set of layers of neurons defined by two features: topology and parameters (also known as weights). The convolutional network may comprise convolutional layers and/or recurrent layers. The topology may be a system of connected computing units. The weights may be numerical coefficients which are assigned to each connection. Each computing unit may output a weighted combination of a corresponding input numerical data and sends this result to neighboring computing units according to the connections. The neural network function may comprise initial units which are fed by input data (that is, the input audio sample) and terminal units which yields the output result (that is, the information relative to presence or absence of passenger voice in the input audio sample). The topology of the neural network, in combination with the weights assigned to each connection, may establish the flow of data from the initial units all the way down to the terminal units.

The machine-learning model may be a binary classifier. This allows to set the training as a classification problem between inferring the presence or absence of passenger voice in the input audio sample. The machine-learning method may train the machine-learning model with a binary-classification loss. In such a case, the dataset may also comprise ground truth data, and the machine-learning method may compare the output of the machine-learning model with the ground truth data so as to evaluate the performance of the training. In examples, the machine-learning model may be a Silero VAD model. Alternatively, the machine-learning model may be a transformer neural network.

The machine-learning model is configured to receive the input audio sample. The machine-learning model may take the input audio sample raw (in other words there is no pre-processing of the input audio sample). The machine-learning model is also configured to output information relative to presence or absence of passenger voice in the input audio sample. In other words, the machine-learning model outputs data indicative of the presence of absence of passenger voice in the input audio sample.

The information relative to presence or absence of passenger voice in the input audio sample may comprise a confidence score. By "confidence score" it is meant a value indicative of the likelihood of the presence of the passenger voice. The confidence score may be for example a probability value, e.g., taking a value of zero if there is an absence of passenger voice in the audio sample (that is, no likelihood of the presence of passenger voice) or one if there is a presence of passenger voice (that is, a high likelihood, e.g., with certainty, of the presence of the passenger). Intermediate values of the confidence score are indicative of the relative likelihood of the presence of passenger voice. For example, the confidence score may take a probability value of 0.5 if there is a 50% probability that there is a presence of passenger voice. A confidence score having a value lower than a threshold (e.g. 0.6 or less) indicates a low likelihood of the presence of passenger voice while a confidence score having a value above the threshold (e.g., 0.5 or more, for example 0.75) indicates a relatively high likelihood of the presence of passenger voice. The predetermined threshold may follow a compromise on accuracy of detection or the efficiency of the implementation.

Such a machine-learning method improves dynamical adjustment of a sound volume of one or more loudspeakers inside a vehicle.

Indeed, the machine-learning method adjusts the weights of the layers of the machine-learning model so that the output of the machine-learning model is information relative to presence or absence of passenger voice in the input audio sample. The information thus enables the dynamical adjustment method to determine the presence or absence of passenger voice in the vehicle and adjusting sound volume of the one or more loudspeakers accordingly.

Moreover, the machine-learning method leverages from convolutional neural networks to infer the presence or absence of passenger voice in the input audio sample, thereby having a high accuracy. The convolutional layers and recurrent layers are configured to find features across multiple samples. Moreover, the recurrent layers are configured to find patterns inside the audio samples. This improves the detection of a presence of passenger voice.

The dynamical adjustment method is further discussed.

The dynamical adjustment method comprises receiving a sequence of consecutive input audio samples from inside a vehicle.

The dynamical adjustment method may comprise capturing the input audio samples at uniform times or alternatively not uniform times. In other words, at a given time, the dynamical adjustment method may comprise capturing an input audio sample of a predetermined interval. The predetermined interval may be set of any duration so as to allow the capturing of the human voice, for example 50 milliseconds or more, for example 96 milliseconds.

The dynamical adjustment method also comprises applying the machine-learning model to each input audio sample, thereby outputting, for each input audio sample, information relative to presence or absence of passenger voice in the input audio sample. The dynamical adjustment method thus obtains output information relative to the presence or absence of passenger voice in the input audio sample. In examples, the dynamical adjustment method obtains a confidence score as explained above.

The dynamical adjustment method may also comprise reducing the sound volume of loudspeakers of the vehicle based on the output information. The dynamical adjustment method may reduce the sound volume of the one or more speakers by a predetermined amount, e.g., 80 per cent less than the sound volume, for example 50 per cent less. Alternatively, the dynamical adjustment method may comprise reducing the sound volume below a set point or even mute the one or more loudspeakers completely. In examples, the dynamical adjustment method may reduce the sound volume when the confidence score is above a predetermined threshold, for example when the confidence threshold is between 0.6 and 1, preferably 0.8. The dynamical adjustment method may continue the capturing while passengers speak. The dynamical adjustment may increase the sound volume when determining that there is an absence of passenger voice, e.g., after a predetermined time, for example 0.5 seconds or more, e.g., 1 second. The dynamical adjustment may return to the previous volume (i.e. go back to the volume previous to when the passenger voice is detected) For example, the dynamical adjustment method may increase the sound volume when the confidence score is below the predetermined threshold, that is, when detecting that there is an absence of the passenger voice, thereby returning to the volume previous to when the passenger voice is detected.

This improves the dynamical adjustment of the sound volume of one or more speakers inside the vehicle. Indeed, the dynamical adjustment method leverages from the trained machine-learning model so as to modify the sound volume according to the presence or absence of the passenger voice. This is because the dynamical adjustment method continuously monitors the passenger voice from inside the vehicle thanks to receiving the sequence of consecutive input audio samples. Thereby, the dynamical adjustment method adapts the sound volume efficiently and seamlessly to the passengers. Moreover, as the machine-learning model is trained with a wide range of scenarios, the dynamical adjustment method detects the presence or absence of passenger voice accurately under a wide range of conditions, thanks to the dynamical adjustment method being data driven due to the machine-learning model being trained based on the dataset.

The dynamical adjustment method may comprise computing a confidence score relative to a presence of passenger voice in the sequence of consecutive input audio samples. The confidence score may be for example a probability value computed from the consecutive sequence. For example, the dynamical adjustment method may output, for each audio sample of the sequence, information relative to a presence or absence of passenger voice. Based on the output of each audio sample, the dynamical adjustment method may output a confidence score for the consecutive sequence , e.g., taking a value of zero if there is an absence of passenger voice in the consecutive sequence (for example when determining that there is an absence of passenger voice on all-or almost all of the audio samples of the sequence ) or one if there is a presence of passenger voice (that is, a high likelihood, e.g., with certainty, of the presence of the passenger). The sequence may comprise a predetermined number of samples, for example one or more, e.g. 100 or more such as 1.000 or more.

The dynamical adjustment method may also comprise reducing the sound volume of loudspeakers of the vehicle if the confidence score is above a predetermined threshold. The confidence score represents a value indicative of the likelihood of the presence of the passenger voice, as explained above. The predetermined threshold may be set in any manner, e.g., via a user input.

Thus, the dynamical adjustment method reduces situations when there may be false positives of the detection of the presence of passenger voice, as the dynamical adjustment method ensures the reduction of the sound when the confidence score is above the predetermined threshold.

The predetermined threshold may be between 0.6 and 1. The predetermined threshold may be preferably 0.8 or more, e.g. 0.9. This ensures that reducing the sound of one or more loudspeakers of the vehicle is made when there is high likelihood that there is a presence of passenger voice.

The dynamical adjustment method may comprise capturing the input audio samples with microphones installed inside the vehicle. The microphones may be for example set in multiple places inside the vehicle so as to allow the detection of passenger voice. In examples, the microphones may be installed close to the driver's seat and/or the co-pilot seat.

Examples of the methods of the present disclosure are now discussed with reference to FIG.s 3 to 9.

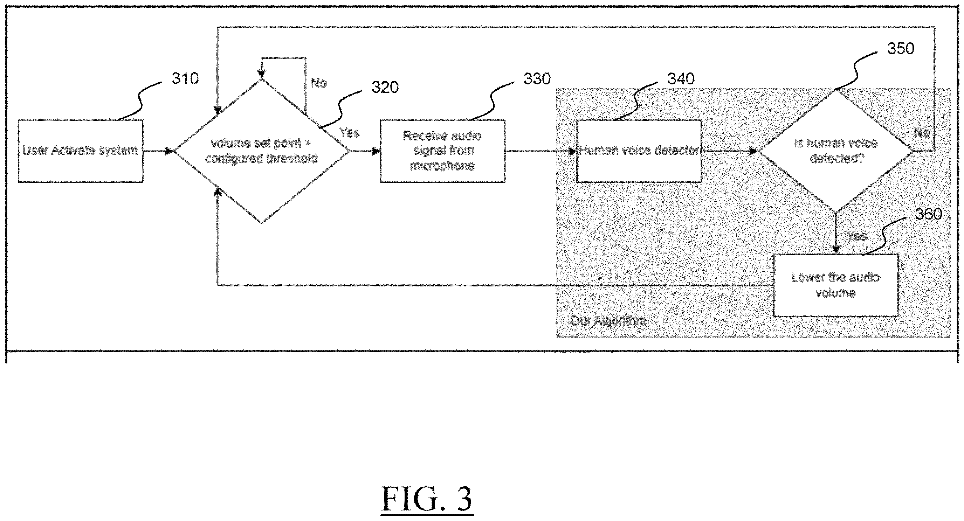

FIG.3 illustrates an overview of the dynamical adjustment method.

The dynamical adjustment method may be activated by a user through an human machine interface (HMI) component 310. The dynamical adjustment method may obtain a set point for the audio volume. The audio volume set point may be set by the user. If the set point is above a predetermined configured threshold 320, the dynamical adjustment method may retain the set point for the steps below. The dynamical adjustment method activates the microphone for capturing audio samples 330. The dynamical adjustment method inputs the audio samples to the machine-learning model 340 (also called Human voice detector). Once a passenger voice is detected 350, the dynamical adjustment method reduces 360 the volume of one or more loudspeakers. Else, the dynamical adjustment method returns to the processing above.

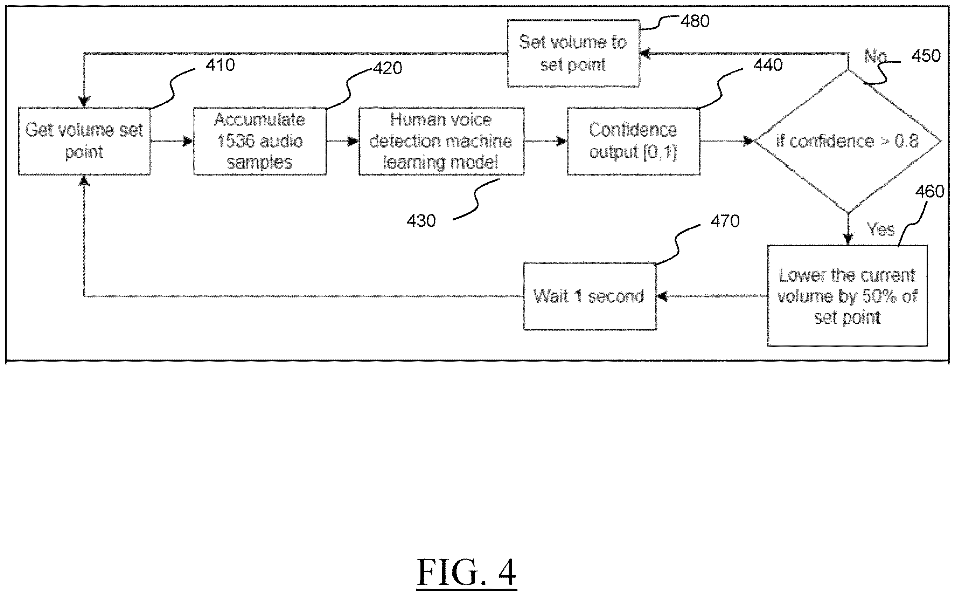

FIG. 4 illustrates the dynamical adjustment method of a sound volume of one or more loudspeakers inside a vehicle using the machine-learning trained according to the training method.

The dynamical adjustment method obtains a volume set point 410. The dynamical adjustment method captures 420 audio samples, in this implementation 1536 consecutive audio samples for a duration of 96ms. The audio samples are input to the machine-learning model 430. The machine-learning model is configured to detect the presence of human voice. The output of the machine-learning model is a confidence score 440 of the presence of human voice in the input audio samples. The confidence score has a value in the range [0,1], where the value 1 means that the machine-learning model is 100% confident that there is a presence of human voice in the audio samples and 0 means otherwise.

If the confidence score is above 450 a threshold of 0.8, the dynamical adjustment method reduces 460 the volume to a value 50% below the set point volume. If after 1 second 470 the dynamical adjustment method does not detect the presence of human voice in the audio sample, the dynamical adjustment method increases the volume to the set point volume. If the confidence score is not above the threshold, the dynamical adjustment method sets the volume to the set point volume.

FIG.s 5 to 8 illustrate an example of the machine-learning model.

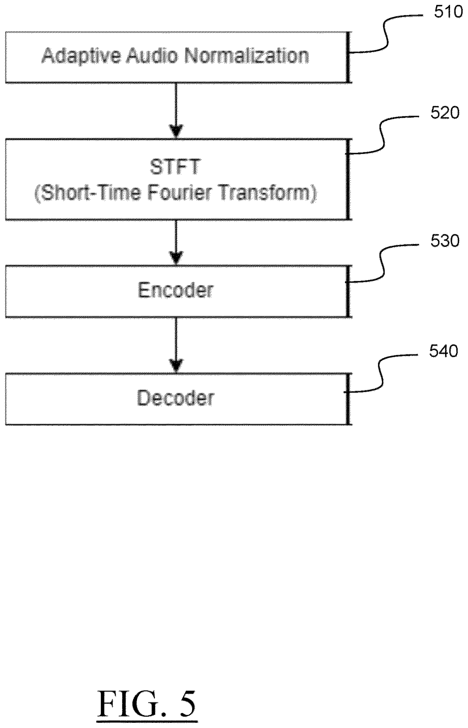

FIG. 5 illustrates the overall architecture of the machine-learning model. The architecture is based on the open source silero-vad architecture. The machine-learning model comprises an adaptive audio normalization module 510, a Short-Time Fourier Transform (STFT) module 520, an Encoder 530 and a Decoder 540.

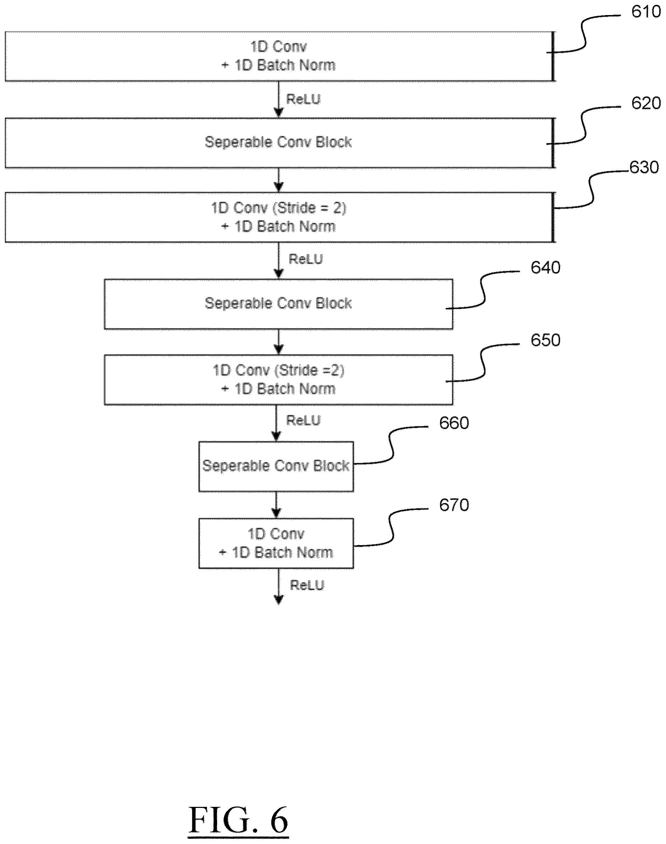

FIG. 6 illustrates the encoder. The encoder comprises a first 1D Convolutional (Conv)+1D Batch Norm 610, a Separable Conv block 620, a second 1D Conv (Stride=2) +1D Batch Norm 630, a Separable Conv Block 640, a third 1D Conv (Stride=2) +1D Batch Norm 650, a Separable Conv Block 660, and a fourth 1D Conv +1D Batch Norm 670

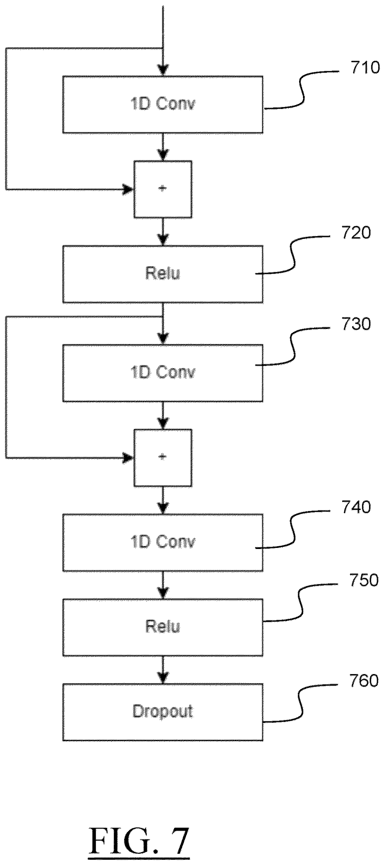

FIG. 7 Illustrates the separable convolution block. The separable convolution block comprises a 1D Conv 710, a Relu 720, a 1D Conv 730, a 1D Conv 740, a Relu 750 and a Dropout 760.

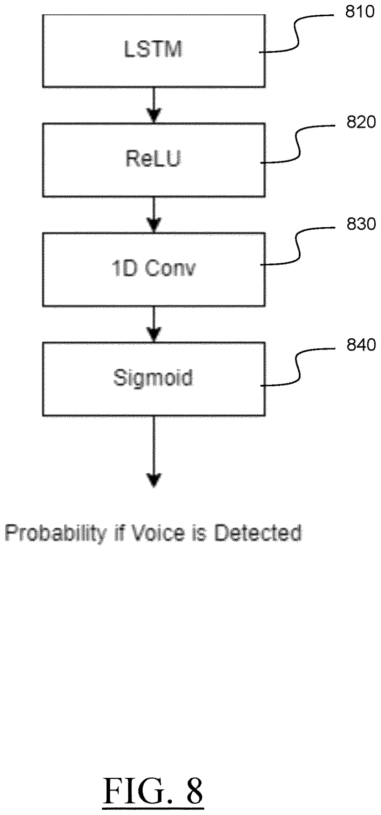

FIG. 8 illustrates the decoder. The decoder comprises a LSTM 810, a Relu 820, a 1D Conv 830 and a Sigmoid 840.

The training set is a mixture of the opensource datasets listed in the below Table I.

**Table I. Mixture of datasets used in the implementation.**

| Name | Number of hours |
|---|---|
| Bible.is | 53,138 |
| Globalrecordings.net | 9,743 |
| VoxLingua107 | 6,628 |
| Common Voice | 30,329 |
| MLS | 50,709 |
| Total | 150,547 |

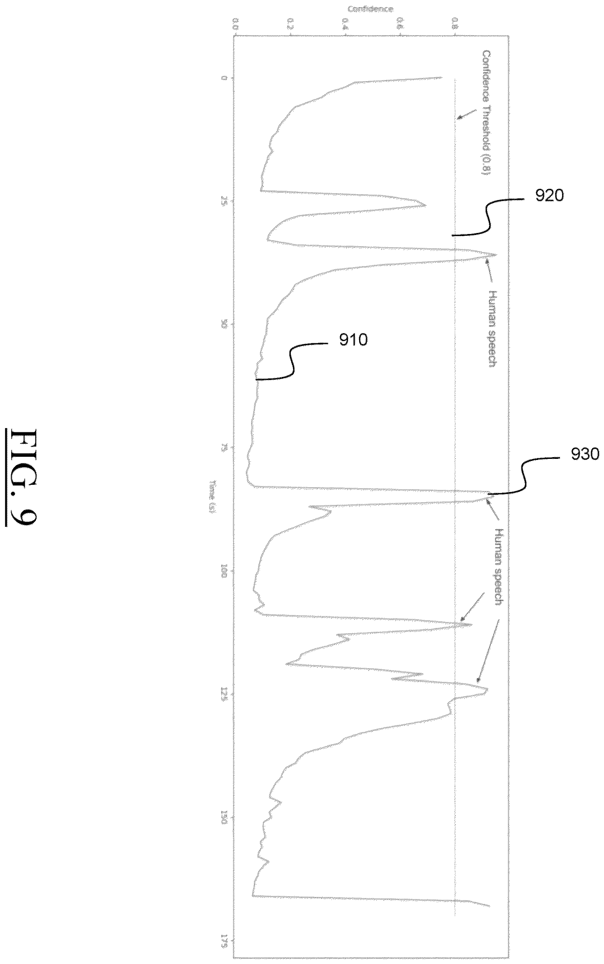

FIG. 9 illustrates an example of the output 910 by the machine-learning model. The experiment is conducted with background music playing during testing inside a vehicle. The output increases to more than the predetermined threshold 920 of 0.8 when the machine-learning model detects the presence of passenger voice, as shown by the peak 930.

## Claims

1. A computer-implemented method of machine-learning for use in a dynamical adjustment of a sound volume of one or more loudspeakers inside a vehicle, the method comprising:
- obtaining a dataset of audio samples, each audio sample having a label representing a presence or absence of passenger voice; and
- training a machine-learning model based on the dataset, the machine-learning model being configured to receive an input audio sample and to output information relative to presence or absence of passenger voice in the input audio sample.

2. The method of claim 1, wherein the information relative to presence or absence of passenger voice in the input audio sample comprises a confidence score.

3. The method of claim 1 or 2, wherein the machine-learning model is a convolutional neural network comprising convolutional layers and/or recurrent layers.

4. The method of any one of claims 1 to 3, wherein the machine-learning model is a binary classifier.

5. A method for dynamical adjustment of a sound volume of one or more loudspeakers inside a vehicle using a machine-learning model trained according to the method of any one of claims 1 to 4, the method comprising:
- receiving a sequence of consecutive input audio samples from inside a vehicle;
- applying the machine-learning model to each input audio sample, thereby outputting, for each input audio sample, information relative to presence or absence of passenger voice in the input audio sample; and
- reducing the sound volume of one or more loudspeakers of the vehicle based on the output information.

6. The method of claim 5, wherein the method comprises:
- computing a confidence score relative to a presence of passenger voice in the sequence of consecutive input audio samples; and
- reducing the sound volume of loudspeakers of the vehicle if the confidence score is above a predetermined threshold.

7. The method of claim 6, wherein the predetermined threshold is between 0.6 and 1, preferably equal to 0.8.

8. The method of any one of claims 5 to 7, wherein the method comprises capturing the input audio samples with microphones installed inside the vehicle.

9. A computer program comprising instructions for performing the method of any of claims 1 to 8.

10. A computer readable storage medium having recorded thereon the computer program of claim 9.

11. A system comprising a processor coupled to a memory, the memory having recorded thereon the computer program of claim 9.

12. A vehicle equipped with the system of claim 11.
